# EUROPEAN PATENT SPECIFICATION

(11) **EP 3 291 287 B1**
(45) Date of publication and mention of the grant of the patent: **10.06.2020**
(21) Application number: 16785903.2
(22) Date of filing: 22.04.2016
(51) Int. Cl.: H01L 21/67, H01L 31/18, F27B 9/02, F27B 9/06, F27B 9/24, F27B 9/36

(54) **ROLLER TYPE SOLAR CELL SINTERING AND IRRADIATION ANNEALING INTEGRATED CONTINUOUS FURNACE**
INTEGRIERTER DURCHLAUFOFEN FÜR SINTERN UND STRAHLGLÜHEN VON ROLLENARTIGEN SOLARZELLEN
FOUR À PASSAGE CONTINU ET INTÉGRÉ DE FRITTAGE ET DE RECUIT PAR IRRADIATION DE CELLULE SOLAIRE DE TYPE ROULEAU

(30) Priority: 25.04.2015 CN 201510203266
(43) Date of publication of application: 07.03.2018
(73) Proprietor: Beijing Solarray Technoiogy Co., Ltd., Beijing 100000 (CN)
(72) Inventor: YUAN, Xiangdong, Beijing 100000 (CN); XU, Ying, Beijing 100000 (CN); YUAN, Xi, Beijing 100000 (CN)
(74) Representative: de Arpe Fernandez, Manuel
(86) International application number: PCT/CN2016/080080
(87) International publication number: WO 2016/173472

(56) References cited:
- CN-A- 101 478 882
- CN-A- 103 681 964
- CN-A- 104 810 309
- CN-U- 202 549 905
- CN-U- 204 537 995
- JP-A- 2001 330 370

## Description

### FIELD OF THE INVENTION

The present invention relates to a roller type solar cell sintering and irradiation annealing integrated continuous furnace which can be used for sintering and irradiation annealing treatment of solar cells.

### BACKGROUND OF THE INVENTION

In an entire production process flow of solar cells, three processes including diffusion, printing and sintering are most important, wherein the sintering process is mainly used for drying paste which acts the metal electrodes and is printed on front and back surfaces of silicon wafers, burning off an organic solvent volatilized from the paste, and synchronously sintering to form a good ohmic contact; Sintering quality directly affects conversion efficiency of the solar cells. Conventionally, the solar cells are sintered by a chain type sintering furnace.

Due to the existence of a boron-oxygen-pair, the efficiency of the solar cells may be degraded under long-term use. Such degradation is serious especially for PERC cells which are introduced in production recently. Researches show that such degradation phenomenon can be prevented effectively by an advanced irradiation annealing treatment process, which use a specific light source at a certain temperature and times. However, there is no this process on the current production line.

Thus, a roller type solar cell sintering and irradiation annealing integrated continuous furnace is provided in the present invention so that the cells are directly and continuously subjected to the irradiation annealing treatment after being sintered, thereby radically solving a problem of mass production in an irradiation annealing process.

### SUMMARY OF THE INVENTION

Aiming at above deficiencies of the prior art, a technical problem to be solved in the present invention according to independent claim 1 and dependent claims 2-10 is to provide a roller type solar cell sintering and irradiation annealing integrated continuous furnace, for radically solving a problem of mass production in an irradiation annealing process, thereby maximally solving a problem of degradation of solar cells.

The roller type solar cell sintering and irradiation annealing integrated continuous furnace in this disclosure composes of a loading and an unloading region, a sintering region, an irradiation annealing region, and a cooling region. Cells are transmitted on a group of horizontally arranged rollers and sequentially pass through the above regions to complete the sintering and irradiation annealing processes of the solar cells at the same time.

Light sources are arranged above the rollers while heating apparatuses are arranged below the rollers; or, the light sources are arranged below the rollers and the heating apparatuses are arranged above the rollers. Front side of the cell is faced the light sources while back side of the cell is faced the heating apparatuses during transmission.

The light sources can be halogen lamps, xenon lamps, incandescent lamps or LED lamps.

The heating apparatuses can be infrared lamp tubes, resistance wires or hot air blowers.

A transparent and heat-insulating material layer is arranged between the light source and the heating region.

Cooling apparatus, such as an air blowing and or an air exhausting apparatus, for cooling the light sources is arranged.

The transparent and heat-insulating material layer is made of quartz glass or toughened glass.

The heating temperature of the heating apparatuses for the cells is 100 °C-300 °C, and preferably 150 °C-250 °C.

The irradiance of the light sources is 50 mW/cm²-200 mW/cm² and preferably 80 mW/cm²-150 mW/cm².

The rollers are made of high-temperature-resistant materials without pollution to the cells such as fused silica ceramic, quartz glass, alumina ceramic, silicon nitride ceramic, stainless steel, aluminum alloy or the like.

The rollers are solid rollers or hollow rollers. The rollers are in the shape of an isodiametric cylinder, steps, truncated cone, thread or annular ring. The rollers can rotate unidirectionally or in a reciprocating manner.

A buffer region is arranged between the sintering and cooling region and the irradiation annealing region. A heating and heat-insulating apparatus suitable for heating and heat-insulating the sintered cells is arranged in the buffer region, or a storage apparatus for temporarily storing the sintered cells is arranged in the buffer region, or a column dividing apparatus for dividing a single column of sintered cells into a plurality of columns to be transmitted to the irradiation annealing region is arranged in the buffer region. The sintered cells can be directly delivered into the irradiation annealing region by maintaining a certain temperature in the buffer region, can be also stored temporarily, and can be also divided from single column into the plurality of columns to be transmitted to the irradiation annealing region.

A set temperature of the heating and heat-insulating apparatus in the buffer region is 50 °C -200 °C.

Compared with the prior art, the present invention has the following beneficial effects:
Roller type solar cell sintering and irradiation annealing integrated continuous furnace provided by the present invention organically combines the sintering process with the irradiation annealing process to form a continuous production line; and the cells are continuously transmitted by the group of horizontally arranged rollers and are continuously subjected to the sintering and irradiation annealing treatment in a horizontal progressing process; therefore, the roller type solar cell sintering and irradiation annealing integrated continuous furnace has advantages of low energy consumption, stable operation, high productivity and continuous production, and can be promoted and applied to solve the problem of degradation of the solar cells during use maximally.

### BRIEF DESCRIPTION OF THE DRAWINGS

In order to describe technical solutions of embodiments of the present invention more clearly, drawings required for describing embodiments will be briefly introduced below. Apparently, the drawings in the following description are only some embodiments of the present invention. Those ordinary skilled in the art can also obtain other drawings based on these drawings without contributing creative efforts.

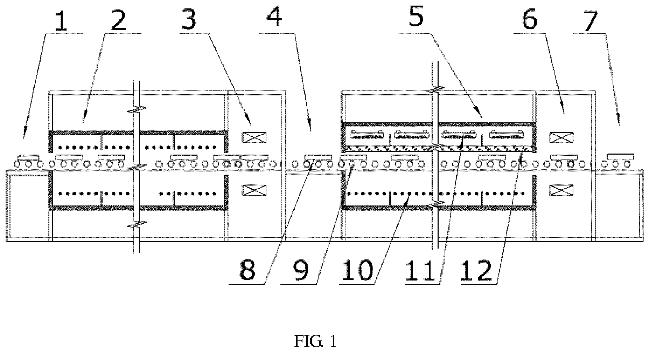

Fig. 1 is a structural schematic diagram of the present invention.

In the figure: 1, loading region; 2, sintering region; 3, sintering and cooling region; 4, buffer region; 5, irradiation annealing region; 6, cooling region; 7, unloading region; 8, cells; 9, roller; 10, heating apparatus; 11, light source; and 12, transparent and heat-insulating material layer.

### DETAILED DESCRIPTION OF THE EMBODIMENTS

Embodiments of the present invention are further described below with reference to the drawings.

### Embodiment 1

As shown in Fig. 1, the roller type solar cell sintering and irradiation annealing integrated continuous furnace is composed of a loading region 1, a sintering region 2, a sintering and cooling region 3, a buffer region 4, an irradiation annealing region 5, a cooling region 6 and an unloading region 7. Rollers 9 are arranged in a horizontal direction and sequentially pass through all the regions. Cells 8 are transmitted forwards on the rollers 9 along with spin of the rollers 9. After entering the loading region 1, the cells 8 enter the sintering region 2 under transmission of the rollers 9 to complete sintering, followed by entering the sintering and cooling region 3. After entering the buffer region 4, the cells are annealed on the irradiation annealing region 5. After irradiation annealing, the cells 8 are cooled in the cooling region 6. Thereby, the entire sintering and irradiation annealing processes are fully complete when entering the unloading region 7.

Heaters are arranged above and/or below the rollers 9 in the sintering region 2; and a cooling apparatus is arranged in the sintering and cooling region 3.

The buffer region 4 is arranged between the sintering and cooling region 3 and the irradiation annealing region 5, and can maintain a certain temperature so that the sintered cells 8 can be directly delivered into the irradiation annealing region 5, can also be stored temporarily, and can be also divided from single column into a plurality of columns to be transmitted to the irradiation annealing region 5.

The irradiation annealing region 5 comprises light sources 11, an upper furnace shell, a transparent and heat-insulating material layer 12, a lower furnace shell and heating apparatuses 10. The rollers 9 penetrate through the furnace chamber. The cells 8 are transferred horizontally by the rollers 9 and enter the irradiation annealing region 5. The heating apparatuses 10 are arranged on a lower portion of the irradiation annealing region 5. The light sources 11 are arranged on an upper portion of the irradiation annealing region 5. An air blowing and cooling apparatus or an air exhausting apparatus for cooling the light sources 11 is arranged in a chamber in which the light sources 11 are mounted. The transparent and heat-insulating material layer 12 is arranged on the lower portion of each of the light sources 11 to isolate a heating region from the light sources 11, thereby preventing heat from burning out the light sources 11. A cooling fan is arranged in the cooling region 6. The cells 8 are cooled by the cooling fan after completing the irradiation annealing, thereby completing the entire irradiation annealing process.

The light sources 11 may be halogen lamps, xenon lamps, incandescent lamps or LED lamps. The heating apparatuses 10 may be infrared lamp tubes, heating wires or hot air blowers. The rollers 9 are solid rollers or hollow rollers. The rollers 9 are in the shape of an isodiametric cylinder, steps, truncated cone, thread or annular ring. The rollers 9 are made of fused silica ceramic, quartz glass, alumina ceramic, silicon nitride ceramic, stainless steel or aluminum alloy. The transparent and heat-insulating material layer 12 is made of quartz glass or toughened glass. In the present embodiment, the used rollers 9 are fused silica ceramic rollers; the light sources 11 are halogen tungsten lamps; the heating apparatuses 10 are the infrared lamp tubes; the transparent and heat-insulating material is a quartz glass plate; the sintering temperature is 800-850 °C; the temperature of the buffer region 4 is generally 50-200 °C and preferably 100-200 °C; a heating temperature of the irradiation annealing region 5 is 100-300 °C and preferably 150-250 °C; and an irradiance of the light sources 11 is 50 mW/cm²-200 mW/cm², and preferably 80 mW/cm²-150 mW/cm².

### Embodiment 2

The light sources 11 are arranged on the lower portion of the irradiation annealing region 5. The heating apparatuses 10 are arranged on the upper portion of the irradiation annealing furnace. The transparent and heat-insulating material layer 12 is arranged between the light sources 11 and bottom surfaces of the rollers 9. The transparent and heat-insulating material layer 12 isolates the heating region on the upper part from the light sources 11. The other components are same as those of embodiment 1.

## Claims

1. A roller type solar cell sintering and irradiation annealing integrated continuous furnace, comprising a loading region (1), a sintering region (2), a sintering and cooling region (3), an irradiation annealing region (5), a cooling region(6) and an unloading region (7), wherein cells (8) are transmitted on a group of horizontally arranged rollers (9) and sequentially pass through the above regions to complete the sintering and irradiation annealing processes of the solar cells at the same time; light sources (11) are arranged above the rollers (9) and heating apparatuses (10) are arranged below the rollers (9); or, the light sources (11) are arranged below the rollers (9) and the heating apparatuses (10) are arranged above the rollers (9); and front sides of the cells (8) are facing the light sources (11), and back sides of the cells (8) are facing the heating apparatuses (10) during the passage through the irradiating annealing region; and a transparent and heat-insulating material layer (12) is arranged between the light sources (11) and the cells (8) to isolate the light sources (11) from the heating apparatus (10).

2. The roller type solar cell sintering and irradiation annealing integrated continuous furnace according to claim 1, wherein the light sources (11) are halogen lamps, xenon lamps, incandescent lamps or LED lamps.

3. The roller type solar cell sintering and irradiation annealing integrated continuous furnace according to claim 1, wherein the heating apparatuses (10) are infrared lamp tubes, heating wires or hot air blowers.

4. The roller type solar cell sintering and irradiation annealing integrated continuous furnace according to claim 1, wherein an air blowing and cooling apparatus or an air exhausting apparatus for cooling the light sources (11) is arranged in a chamber in which the light sources (11) are mounted.

5. The roller type solar cell sintering and irradiation annealing integrated continuous furnace according to claim 1, wherein the transparent and heat-insulating material layer (12) is made of quartz glass or toughened glass.

6. The roller type solar cell sintering and irradiation annealing integrated continuous furnace according to claim 1, wherein the heating temperature of the heating apparatuses (10) for the cells (8) is 100-300 °C.

7. The roller type solar cell sintering and irradiation annealing integrated continuous furnace according to claim 1, wherein an irradiance of the light sources (11) is 50-200 mW/cm².

8. The roller type solar cell sintering and irradiation annealing integrated continuous furnace according to claim 1, wherein the rollers (9) are made of fused silica ceramic, quartz glass, alumina ceramic, silicon nitride ceramic, stainless steel or aluminum alloy.

9. The roller type solar cell sintering and irradiation annealing integrated continuous furnace according to claim 1, wherein the rollers (9) are solid rollers or hollow rollers; and the rollers (9) are in the shape of an isodiametric cylinder, steps, truncated cone, thread or annular ring.

10. The roller type solar cell sintering and irradiation annealing integrated continuous furnace according to any one of claims 1-9, wherein a buffer region (4) is arranged between the sintering and cooling region (3) and the irradiation annealing region (5); and a heating and heat-insulating apparatus capable of heating and heat-insulating the sintered cells (8) is arranged in the buffer region (4), or a storage apparatus for temporarily storing the sintered cells (8) is arranged in the buffer region (4), or a column dividing apparatus for dividing a single column of the sintered cells (8) into a plurality of columns to be transmitted to the irradiation annealing region (5) is arranged in the buffer region (4).

## Patentansprüche

1. Integrierter kontinuierlicher Ofen zum Sintern und Bestrahlungsglühen der Solarzellen des Walzentyps, umfassend einen Ladebereich (1), einen Sinterbereich (2), einen Sinter- und Kühlbereich (3), einen Bestrahlungsglühbereich (5), eine Kühlbereich (6) und einen Entladebereich (7), wobei Zellen (8) auf einer Gruppe von horizontal angeordneten Walzen (9) übertragen werden und nacheinander durch die obigen Bereiche gehen, um die Sinter- und Bestrahlungsglühprozesse der Solarzellen gleichzeitig abzuschließen; und wobei Lichtquellen (11) über den Walzen (9) angeordnet und Heizvorrichtungen (10) unter den Walzen (9) angeordnet sind; oder die Lichtquellen (11) unter den Walzen (9) angeordnet und die Heizvorrichtungen (10) über den Walzen (9) angeordnet sind; und wobei während des Durchgangs durch den Bestrahlungsglühbereichdie Vorderseiten der Zellen (8) den Lichtquellen (11) zugewandtund die Rückseiten der Zellen (8) den Heizvorrichtungen (10) zugewandt sind; und wobei eine transparente und wärmeisolierende Materialschicht (12) zwischen den Lichtquellen (11) und den Zellen (8) angeordnet sind, um die Lichtquellen (11) von der Heizvorrichtung (10) zu isolieren.

2. Integrierter kontinuierlicher Ofen zum Sintern und Bestrahlungsglühen der Solarzellen des Walzentyps nach Anspruch 1, wobei die Lichtquellen (11) Halogenlampen, Xenonlampen, Glühlampen oder LED-Lampen sind.

3. Integrierter kontinuierlicher Ofen zum Sintern und Bestrahlungsglühen der Solarzellen des Walzentyps nach Anspruch 1, wobei die Heizvorrichtungen (10) Infrarotlampenrohre, Heizdrähte oder Heißluftgebläse sind.

4. Integrierter kontinuierlicher Ofen zum Sintern und Bestrahlungsglühen der Solarzellen des Walzentyps nach Anspruch 1, wobei eine Luftblas- und Kühlvorrichtung oder eine Luftabsaugvorrichtung zum Kühlen der Lichtquellen (11) in einer Kammer angeordnet ist, in der die Lichtquellen (11) montiert sind.

5. Integrierter kontinuierlicher Ofen zum Sintern und Bestrahlungsglühen der Solarzellen des Walzentyps nach Anspruch 1, wobei die transparente und wärmeisolierende Materialschicht (12) aus Quarzglas oder gehärtetem Glas besteht.

6. Integrierter kontinuierlicher Ofen zum Sintern und Bestrahlungsglühen der Solarzellen des Walzentyps nach Anspruch 1, wobei die Erwärmungstemperatur der Heizvorrichtungen (10) für die Zellen (8) 100-300°C beträgt.

7. Integrierter kontinuierlicher Ofen zum Sintern und Bestrahlungsglühen der Solarzellen des Walzentyps nach Anspruch 1, wobei eine Bestrahlungsstärke der Lichtquellen (11) 50-200 mW/cm² beträgt.

8. Integrierter kontinuierlicher Ofen zum Sintern und Bestrahlungsglühen der Solarzellen des Walzentyps nach Anspruch 1, wobei die Walzen (9) aus Quarzglaskeramik, Quarzglas, Aluminiumoxidkeramik, Siliziumnitridkeramik, Edelstahl oder Aluminiumlegierung bestehen.

9. Integrierter kontinuierlicher Ofen zum Sintern und Bestrahlungsglühen der Solarzellen des Walzentyps nach Anspruch 1, wobei die Walzen (9) massive Walzen oder hohle Walzen sind; und wobei die Walzen (9) in Form eines isodiametrischen Zylinders, der Stufen, eines Kegelstumpfes, eines Gewindes oder eines Ringes ausgebildet sind.

10. Integrierter kontinuierlicher Ofen zum Sintern und Bestrahlungsglühen der Solarzellen des Walzentyps nach einem der Ansprüche 1 bis 9, wobei ein Pufferbereich (4) zwischen dem Sinter- und Kühlbereich (3) und dem Bestrahlungsglühbereich (5) angeordnet ist; und wobei eine Heiz- und Wärmeisoliervorrichtung, die die gesinterten Zellen (8) erwärmen und wärmeisolieren kann, in dem Pufferbereich (4) angeordnet ist, oder eine Speichervorrichtung zum vorübergehenden Speichern der Sinterzellen (8) in dem Pufferbereich angeordnet (4) ist, oder eine Säulenteilvorrichtung zum Teilen einer einzelnen Säule der gesinterten Zellen (8) in mehrere Säulen, die auf den Bestrahlungsglühbereich (5) übertragen werden sollen, in dem Pufferbereich (4) angeordnet ist.

## Revendications

1. Four continu à rouleaux intégré de frittage et de recuit par irradiation de cellules solaires, comprenant une région de chargement (1), une région de frittage (2), une région de frittage et de refroidissement (3), une région de recuit par irradiation (5), une région de refroidissement (6) et une région de déchargement (7), dans lequel les cellules (8) sont transmises sur un groupe de rouleaux (9) disposés horizontalement et traversent séquentiellement les régions ci-dessus pour achever les processus de frittage et de recuit par irradiation des cellules solaires en même temps; des sources de lumière (11) sont disposées au-dessus des rouleaux (9) et des appareils de chauffage (10) sont disposés au-dessous des rouleaux (9); ou, les sources de lumière (11) sont disposées au-dessous des rouleaux (9) et les appareils de chauffage (10) sont disposés au-dessus des rouleaux (9); et des côtés avant des cellules (8) font face aux sources de lumière (11), et des côtés arrière des cellules (8) font face aux appareils de chauffage (10) pendant le passage à travers la région de recuit irradiant; et une couche de matériau transparent et calorifuge (12) est disposée entre les sources de lumière (11) et les cellules (8) pour isoler les sources de lumière (11) de l'appareil de chauffage (10).

2. Four continu à rouleaux intégré de frittage et de recuit par irradiation de cellules solaires selon la revendication 1, dans lequel les sources de lumière (11) sont des lampes halogènes, des lampes à xénon, des lampes à incandescence ou des lampes LED.

3. Four continu à rouleaux intégré de frittage et de recuit par irradiation de cellules solaires selon la revendication 1, dans lequel les appareils de chauffage (10) sont des tubes de lampe infrarouge, des fils chauffants ou des soufflantes d'air chaud.

4. Four continu à rouleaux intégré de frittage et de recuit par irradiation de cellules solaires selon la revendication 1, dans lequel un appareil de soufflage et de refroidissement d'air ou un appareil d'évacuation d'air pour refroidir les sources de lumière (11) est disposé dans une chambre dans laquelle les sources de lumière (11) sont montées.

5. Four continu à rouleaux intégré de frittage et de recuit par irradiation de cellules solaires selon la revendication 1, dans lequel la couche de matériau transparent et calorifuge (12) est en verre de quartz ou en verre trempé.

6. Four continu à rouleaux intégré de frittage et de recuit par irradiation de cellules solaires selon la revendication 1, dans lequel la température de chauffage des appareils de chauffage (10) pour les cellules (8) est de 100-300°C.

7. Four continu à rouleaux intégré de frittage et de recuit par irradiation de cellules solaires selon la revendication 1, dans lequel un rayonnement des sources lumineuses (11) est de 50-200 mW/cm².

8. Four continu à rouleaux intégré de frittage et de recuit par irradiation de cellules solaires selon la revendication 1, dans lequel les rouleaux (9) sont en céramique de silice fondue, verre de quartz, céramique d'alumine, céramique de nitrure de silicium, acier inoxydable ou alliage d'aluminium.

9. Four continu à rouleaux intégré de frittage et de recuit par irradiation de cellules selon la revendication 1, dans lequel les rouleaux (9) sont des rouleaux pleins ou des rouleaux creux; et les rouleaux (9) ont la forme d'un cylindre isodiamétrique, de marches, d'un cône tronqué, d'un filetage ou d'une bague annulaire.

10. Four continu à rouleaux intégré de frittage et de recuit par irradiation de cellules selon l'une quelconque des revendications 1 à 9, dans lequel une région tampon (4) est disposée entre la région de frittage et de refroidissement (3) et la région de recuit d'irradiation (5); et un appareil de chauffage et d'isolation thermique capable de chauffer et d'isoler la chaleur des cellules frittées (8) est disposé dans la région tampon (4), ou un appareil de stockage pour stocker temporairement les cellules frittées (8) est disposé dans la région tampon (4), ou un appareil de division de colonne pour diviser une seule colonne des cellules frittées (8) en une pluralité de colonnes à transmettre à la région de recuit par irradiation (5) est disposé dans la région tampon (4).
